# EUROPEAN PATENT APPLICATION

(11) **EP 1 914 800 A1**
(43) Date of publication of application: **23.04.2008**
(21) Application number: 06022046.4
(22) Date of filing: 20.10.2006
(51) Int. Cl.: H01L 21/8234, H01L 21/8238, H01L 27/088, H01L 27/092

(54) **Method of manufacturing a semiconductor device with multiple dielectrics**

(71) Applicant: Interuniversitair Microelektronica Centrum, 3001 Leuven (BE)
(72) Inventor: Tigelaar, Howard, Allen, TX 75013 (US); Kubicek, Stefan, 3212 Pellenberg (BE); Yu, Hong Yu, 3001 Leuven (BE)
(74) Representative: Bird, William Edward

(57) **Abstract**

A method is disclosed of manufacturing a semiconductor device with at least a first dielectric material (202) and a second dielectric material (203). The method providing a first dielectric material (202) on a substrate (200); providing a patterned sacrificial layer (204) covering the first dielectric material (200) in at least a first region (210a) of the substrate (200); providing a second dielectric material (203) covering the patterned sacrificial layer (204) in the first region (210a) and covering the first dielectric material (202) in at least a second region (210b), the second region (210b) being different from the first region (210a); patterning the second dielectric material (203) such that the patterned second dielectric material (203) covers the first dielectric material (202) in the second region (210b) but not the patterned sacrificial layer (204) in the first region (210a); and removing the patterned sacrificial material (204). Next, a first and/or second electrode (206, 508) may be provided. Additionally a third dielectric material (307) may be provided. The second and third dielectric material (203, 307) may serve for tuning the workfunction of the first and/or second electrode (206, 508) of the semiconductor device.

## Description

### Field of the invention

The present invention generally relates to semiconductor devices. More specifically, this invention relates to the fabrication of semiconductor devices comprising semiconductor structure comprising different dielectric materials. For example, the present invention may relate to complementary metal oxide semiconductor (CMOS) devices.

### Background of the invention

Up to now, semiconductor industry remains driven by scaling geometric dimensions of metal-oxide-semiconductor field-effect-transistors (MOSFETs). With traditional MOSFET-technology, using silicon dioxide (SiO₂) as gate dielectric and polycrystalline silicon (poly-Si) as gate material, a lot of problems occur when scaling down to 100 nm or below.

As the gate dielectric thickness is reduced, an exponential increase of gate direct tunneling currents occurs. One solution to solve this problem for a 45 nm node and beyond is the introduction of so-called high-k dielectrics as gate dielectric. A high-k dielectric is a dielectric featuring a dielectric constant (k) higher than the dielectric constant of SiO₂, i.e. k > 3.9. High-k dielectrics allow for a larger physical thickness (compared to SiO₂) for obtaining a same effective capacitance than can be obtained with a much thinner SiO₂ layer. The larger physical thickness of the high-k material will reduce gate leakage currents.

Together with the gate dielectric scaling, also gate dimensions are scaled down. However, for SiO₂ oxide thicknesses below 2 nm, a polysilicon (poly-Si) depletion effect starts to become dominant in the poly-Si gate. A solution to this problem is the introduction of metals as gate material. Advantages of metal gates are elimination of the polysilicon depletion effect, very low resistance, no dopant penetration possible and better compatibility with high-k gate dielectrics.

However, by introducing metal gates, the threshold voltage of the MOSFET becomes controlled by the metal workfunction. The fabrication of MOSFETs (both nMOSFET and pMOSFET) with metal gates comparable to polysilicon gate MOSFETs has remained a huge challenge to industry researchers, because the effective workfunction of metal electrodes is affected by several factors, including composition, underlying dielectric and heat cycles during processing.

The introduction of new materials, such as high-k dielectrics and metal gate electrodes, is not simple, since problems may occur in the fabrication process steps like etch and strip. Also high thermal budgets can form a problem. Hence, for the integration of high-k dielectric and metal gate electrodes in a complementary metal-oxide-semiconductor (CMOS) device, new alternatives have to be introduced in the process flow.

Regarding metal gate electrodes, tuning of the workfunction is not straightforward as a different workfunction is needed for NMOS than for PMOS. Whereas the workfunction of a polysilicon gate electrode can be tuned by ion implantation, the workfunction of a metal gate electrode is a material property which cannot be changed easily.

Depending on the requirements for the workfunction of the metal gates, several integration schemes are possible to integrate metal gates into a CMOS process flow such as, for example, using fully-silicided metal gates (FUSI), using two different band-edge metal gates or using a single metal gate with selectively tuned work function to produce desired values for n-channel and p-channel devices.

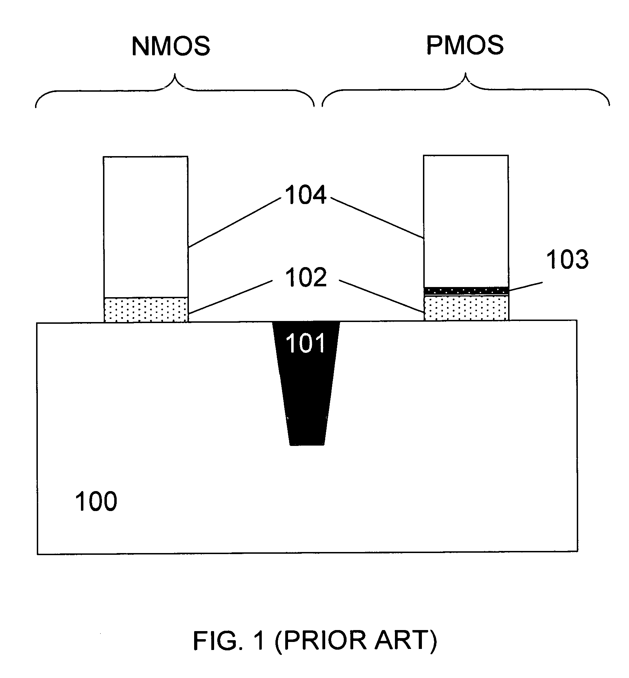

To tune the workfunction of NMOS and PMOS transistors independently it may be necessary to be able to put different dielectric materials or a different dielectric capping layer on the NMOS and PMOS transistor. For the integration of different dielectric material for NMOS and PMOS, the dielectric material is blanket deposited on the wafer and must be removed from one of the n-type or p-type transistor. For example in the publication of Hyung-Suk Jung et al. and presented at 2006 Symposium on VLSI Technology a dual high-k gate dielectric technology is proposed using a selective AlOₓ etch process with nitrogen and fluorine incorporation. The final result is shown in FIG. 1. In substrate 100 a PMOS and a NMOS region are defined using shallow trench isolation (STI) 101. The CMOS device comprises a HfSiO 102/poly-Si 104 stack for NMOS and a HfSiO 102/AlOx 103/poly-Si 104 stack for PMOS. In the process integration scheme a dielectric capping layer of AlOₓ 103 is provided on the high-k dielectric 102 to tune the workfunction of the PMOS transistor. After the deposition of the high-k dielectric 102 (HfSiO) a first post deposition annealing is performed to have a better selectivity to a HF etching solution. After the deposition of the AlOₓ 103 on the HfSiO 102, a second post deposition annealing is performed. Following photoresist patterning to block the PMOS region, AlOₓ 103 is removed from the NMOS region by a HF solution. After poly-Si deposition 104 a standard CMOS integration sequence can be employed for the remaining process steps.

The main disadvantage with prior art solutions, as for example presented in the publication of Hyung-Suk Jung et al., is that it is difficult to remove the dielectric capping material without damaging the underlying high-k dielectric.

### Summary of the invention

The aim of the present invention is to provide a good method for manufacturing a semiconductor device with multiple dielectrics.

It is an advantage of the present invention that a same dielectric material, also referred to as host dielectric material, is used for different semiconductor structures of a semiconductor device. Since one host dielectric (i.e. first dielectric material) is used for the different semiconductor structures, the process comes close to well-known conventional CMOS processes and gives better control of the integrity performance of the gate dielectric material.

It is an advantage of the present invention that a second dielectric material and/or third dielectric material can be provided without damaging the underlying first dielectric material. The host dielectric material (i.e. first dielectric material) remains intact during the whole process due to the use of a sacrificial layer.

A method is disclosed for manufacturing a semiconductor device comprising providing a first dielectric material on a substrate; providing a patterned sacrificial layer covering the first dielectric material in at least a first region of the substrate; providing a second dielectric material covering the patterned sacrificial layer in the first region and covering the first dielectric material in at least a second region of the substrate, the second region being different from the first region; patterning the second dielectric material such that the patterned second dielectric material covers the first dielectric material in the second region but not the patterned sacrificial layer in the first region; and removing the patterned sacrificial layer.

In a preferred embodiment of the present invention removing the patterned sacrificial layer may be performed without damaging the first dielectric material covered by the sacrificial layer.

In another preferred embodiment of the present invention the method of manufacturing a semiconductor device may further comprise providing a first electrode in the first region and a second electrode in the second region.

The first electrode and the second electrode may be formed of a same layer of electrode material. Alternatively the first electrode and the second electrode may be formed of different layers of electrode material.

Said electrode material may be a metal comprising material. The metal comprising material comprises any of a metal, a metal alloy, a metal silicide, a conductive metal nitride or a conductive metal oxide. Said electrode material may comprise Ta, Hf, Mo, W or Ru. Said electrode material may also be a polysilicon.

Said first and/or second electrode may be a silicided electrode. Said silicided first and/or second electrode are preferably fully silicided.

In another preferred embodiment of the present invention the method of manufacturing a semiconductor device may further comprise, after providing the second dielectric material, forming the second electrode on and in contact with the second dielectric material and patterning the second electrode such that the second electrode covers the second dielectric material in the second region but not the first dielectric material in the first region, wherein patterning the second electrode and patterning the second dielectric material is performed simultaneously.

The first dielectric material may comprise a silicon based dielectric material. The silicon based dielectric material may comprise SiO₂ Si₃N₄ or SiON.

The first dielectric material may comprise a high-k dielectric material. The high-k dielectric material may comprise Al₂O₃, Si₃N₄, Gd₂O₃, Yb₂O₃, Dy₂O₃, Nb₂O₅, Y₂O₃, La₂O₃, ZrO₂, HfO₂, TiO₂, Ta₂O₅, SrTiO₃, BaₓSr₁₋ₓTiO₃, ZrO₂₅, ZrₓSi₁₋ₓO_{y}, HfₓSi₁₋ₓO_{y}, AlₓZr₁₋ₓO₂, Pr₂O₃ or any combination thereof.

The second dielectric material may comprise a material suitable for tuning the workfunction of the first and/or second electrode. The second dielectric material may be a dielectric capping layer. The second dielectric material may comprise LaO (N), A10(N), AlN, DyO(N), ScO(N), GdO(N), CeO(N), TbO(N), ErO(N), YbO(N) or any combination thereof.

The sacrificial layer may comprise TiN, Ge or amorphous carbon.

The first dielectric material may have an equivalent oxide thickness in the range of 2 Å to 30 Å.

The second dielectric material may have an equivalent oxide thickness in the range of 2 Å to 10 Å.

The sacrificial layer may have a thickness in the range of 5 nm to 100 nm.

In another preferred embodiment of the present invention the method of manufacturing a semiconductor device may further comprise providing a third dielectric material in between the first dielectric material and the first electrode in the first region.

Providing said third dielectric material may comprise providing the third dielectric material covering the first dielectric material in the first region and covering the second dielectric material in the second region; patterning the third dielectric material such that the patterned third dielectric material covers the first dielectric material in the first region but not the second dielectric material in the second region.

The third dielectric material may comprise a material suitable for tuning the workfunction of the first and/or second electrode. The third dielectric material may comprise LaO(N), AlO(N), AlN, DyO(N), ScO(N), GdO(N), CeO(N), TbO(N), ErO(N), YbO(N) or any combination thereof. The third dielectric material may have an equivalent oxide thickness in the range of 2 Å to 10 Å.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Description of the drawings

All drawings are intended to illustrate some aspects and embodiments of the present invention. The drawings described are only schematic and are non-limiting. In the drawings, the size of some of the elements may be exaggerated and not drawn on scale for illustrative purposes.

Exemplary embodiments are illustrated in referenced figures of the drawings. It is intended that the embodiments and figures disclosed herein be considered illustrative rather than restrictive.

Figure 1 (PRIOR ART) is a schematic representation of a dual high-k gate dielectric technology.

Figure 2A-H represents an embodiment of a method in accordance with the present invention for manufacturing a semiconductor device with two different gate dielectric for the first region and second region.

Figure 3A-K represents an embodiment of a method in accordance with the present invention for manufacturing a semiconductor device with three different gate dielectric for the first region and second region.

Figure 4A-I represents an embodiment of a method in accordance with the present invention for manufacturing a semiconductor device with two different gate dielectric for the first region and second region and with different gate electrode for the first region and second region.

Figure 5A-J represents an embodiment of a method in accordance with the present invention for manufacturing a semiconductor device with three different gate dielectric for the first region and second region and with different gate electrode for the first region and second region.

Figure 6 represents a flow chart illustrating the method according to embodiments of the present invention.

### Detailed description

One or more embodiments of the present invention will now be described in detail with reference to the attached figures, the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention. Those skilled in the art can recognize numerous variations and modifications of this invention that are encompassed by its scope. Accordingly, the description of preferred embodiments should not be deemed to limit the scope of the present invention.

Furthermore, the terms first, second and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein. For example "underneath" and "above" an element indicates being located at opposite sides of this element.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

In the following, certain embodiments will be described with reference device structures such as field effect transistors having a drain, source and gate but the inventive aspect is not limited thereto. In the following certain embodiments will also be described with reference to a silicon substrate but it should be understood that certain inventive aspects apply equally well to other semiconductor substrates. In embodiments, the "substrate" may include a semiconductor substrate such as e.g. a silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. Accordingly a substrate may be a wafer such as a blanket wafer or may be a layer applied to another base material, e.g. an epitaxial layer grown onto a lower layer.

Some embodiments are suitable for integration into CMOS processing to provide CMOS devices. In such processing active regions can be formed by doping a semiconductor layer. An active region is defined as any region which becomes active due to the implantation of a dopant such as As, B, Ph, Sb, etc. In a MOS device this active region is often referred to as source and/or drain region. However, certain inventive aspects are not limited thereto.

The present invention provides a method of manufacturing a semiconductor device comprising different semiconductor structures and comprising at least a first and a second dielectric material. According to the method of the present invention, a sacrificial layer is used which can be removed without damaging the underlying dielectric material.

The method according to the present invention comprises providing a first dielectric on a substrate; providing a patterned sacrificial covering the first dielectric material in at least a first region of the substrate; providing a second dielectric covering the patterned sacrificial layer in said first region and covering the first dielectric material in at least a second region of the substrate, the second region being different from the first region; patterning said second dielectric material such that said patterned second dielectric material covers the first dielectric material in said second region but not the patterned sacrificial layer in the first region; and removing said patterned sacrificial material.

The method according to the invention may be used in many methods for fabricating semiconductor devices. One example is the manufacture of semiconductor devices comprising different semiconductor structures, each having a control electrode, for example gate electrode, and at least two main electrodes, for example a source and a drain electrode. In the description hereinafter, a method is described for the manufacturing of a semiconductor device having two semiconductor structures, each with a gate electrode as control electrode and a source and a drain region as first and second main electrodes. This example is used only for the ease of explanation and is not intended to be limiting for the invention.

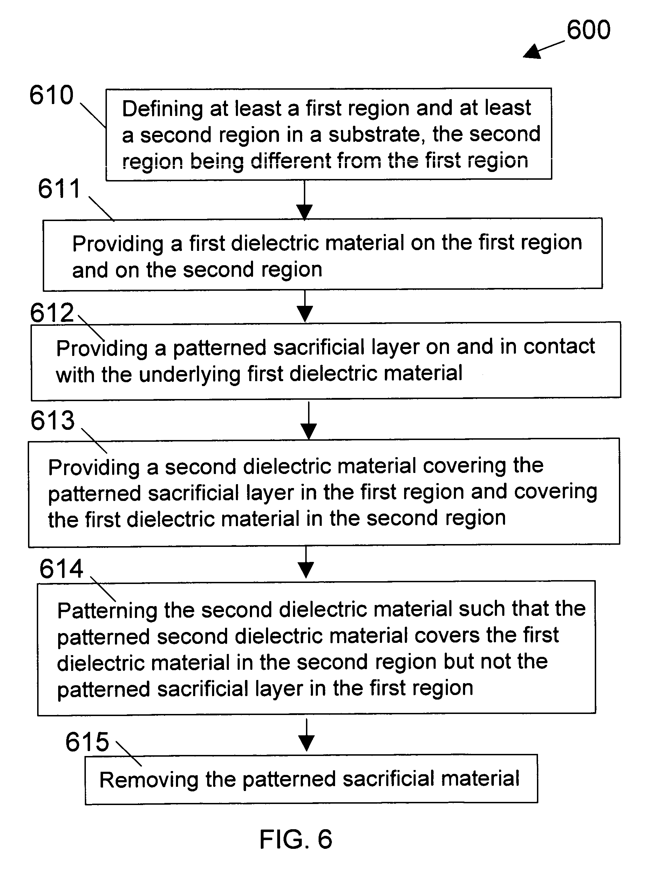

The method for manufacturing a semiconductor device according to embodiments of the present invention is shown in a flow chart in FIG. 6, illustrating different steps.

A first step 610 may comprise defining at least a first region in a substrate and defining at least a second region in said substrate, the first region being different from the second region. The substrate may be any type of substrate as described above. With first region is meant at least part of the substrate. With second region is meant at least another part of the substrate. There is no overlap between the first region and the second region. The first and second region may be separated using isolation between said first and said second region, such as, for example, shallow trench isolation (STI) zones or local oxidation of silicon (LOCOS) zones.

In a second step 611 a first dielectric material is provided on the substrate, in the example given on said first and said second region of said substrate. Said first dielectric material may cover the whole substrate or only parts thereof. Said first dielectric material acts as a host dielectric material which is the same for the complete semiconductor device, i.e. for the different semiconductor structures formed on the substrate. In the example given, the first or host dielectric material is the same for both the first region and the second region. With host dielectric material is meant that the dielectric material is used for the main purpose as a control electrode dielectric, e.g. gate dielectric, in a semiconductor device, namely as a dielectric barrier between the control electrode, e.g. gate electrode, and a channel region of the semiconductor structures forming the semiconductor device.

In a third step 612, a patterned sacrificial layer is provided, covering the first dielectric material in at least a first region of the substrate. Said patterned sacrificial layer is on and in contact with said underlying first dielectric material in said first region. With 'in contact with' is meant that the sacrificial layer is in direct contact with the first dielectric material which is positioned in between the substrate and the sacrificial layer, in other words that the sacrificial layer is in direct contact with the dielectric material which is lying under the patterned sacrificial layer. With 'sacrificial' is meant that the layer does not have any function for the proper working of the semiconductor device formed by the method according to embodiments of the present invention. In other words, the sacrificial layer is not necessary for the proper electrical working of the semiconductor device. The sacrificial layer serves as an aid in the process flow or in the different steps of the method according to the present invention. It is an advantage of the present invention that the sacrificial layer is used to prevent damage to the underlying material, i.e. the underlying first dielectric material, i.e the underlying host dielectric material, during following process steps such as etching or removal steps.

A next step 613 comprises providing a second dielectric material covering the patterned sacrificial layer in the first region and covering the first dielectric material in the second region. Said second dielectric material is on and in direct contact with said patterned sacrificial layer in said first region and on and in direct contact with said first gate dielectric in said second region. In other words, in the first region the sacrificial layer is sandwiched in between the second dielectric material and the first dielectric material, whereas in the second region the second dielectric material is positioned on and in direct contact with the first dielectric material. In the second region, the first dielectric material is thus sandwiched in between the substrate and the second dielectric material. The second dielectric material is used to adjust the workfunction in the second region to the desired value.

In a next step 614, said second dielectric material is patterned such that the patterned second dielectric material covers the first dielectric material in the second region but not the patterned sacrificial layer in the first region. Said patterned second dielectric material remains on and in direct contact with said first dielectric material in said second region. In other words, the second dielectric material is not present anymore in the first region after patterning the second dielectric material.

In a next step 615 said patterned sacrificial layer is removed. The removal of the patterned sacrificial layer is performed substantially without damaging the underlying first dielectric material.

The invention will now further be described by a detailed description of several particular embodiments of the invention. It is clear that other embodiments of the invention can be configured according to the knowledge of persons skilled in the art without departing from the true spirit or technical teaching of the invention, the invention being limited only by the terms of the appended claims.

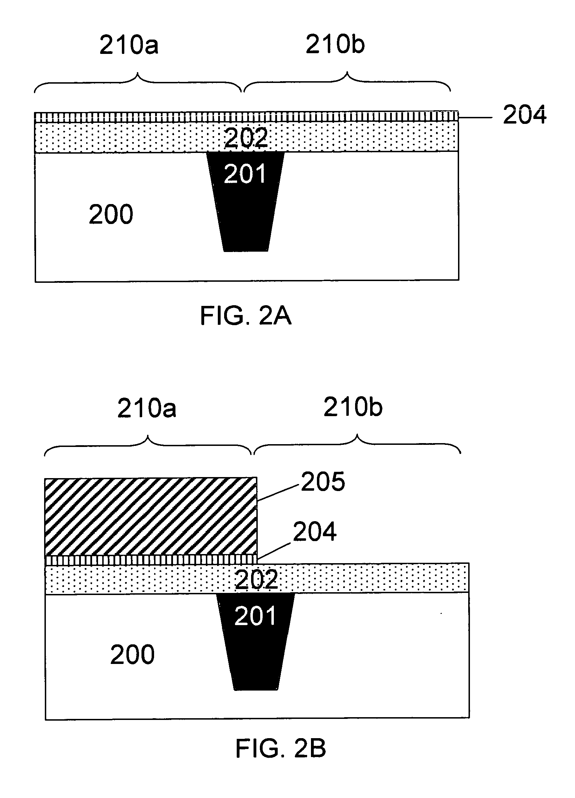

FIGS. 2A-2H illustrate the method for manufacturing a semiconductor device with multiple dielectric materials on a semiconductor substrate 200 according to an embodiment of the present invention using a sacrificial layer which can be removed without damaging the underlying dielectric material.

In a first step according to this embodiment of the invention at least a first region and a second region may be defined in the substrate (FIG. 2A). Preferably, the substrate 200 may comprise multiple distinct regions. Most preferably two distinct regions may be defined in the substrate 200, as is illustrated in Fig. 2A: a first region 210a (left-hand as viewed) and a second region 210b (right-hand as viewed). The second region is distinct and not overlapping with the first region. Said first region may present, for example, an NMOS region of said semiconductor device; said second region may present, for example, a PMOS region of said semiconductor device; or vice versa. A possible way to isolate said first and second region from each other is by using shallow trench isolation (STI) 201 in between. STI is a deep narrow trench, filled with oxide, etched into the semiconductor substrate in between adjacent devices in an integrated circuit to provide electrical isolation between. Alternatively, local oxidation of silicon (LOCOS) may be used. Alternatively, mesa isolation may be used as for example in the case when silicon-on-insulator (SOI) substrate is used.

First, the surface of the substrate 200 may be pre-cleaned with standard cleaning techniques, such as, for example, RCA clean, to remove any organic contaminants or native oxide on the wafer surface or semiconductor substrate.

In a next step according to the present embodiment of the invention a first dielectric material 202 is provided on the substrate 200 (FIG.2A).

The first dielectric material 202 may preferably comprise a high-k dielectric material. According to embodiments of the invention, the high-k material may have a k value of greater than 3.9, e.g. higher than 4, such as in the range 4 to 30. Typical values range from 10 to 12. Examples of dielectric materials having a dielectric constant of about 4 or higher are, for example, Al₂O₃, Si₃N₄, Gd₂O₃, Yb₂O₃, Dy₂O₃, Nb₂O₅, Y₂O₃, La₂O₃, ZrO₂, HfO₂, TiO₂, Ta₂O₅, SrTiO₃, BaₓSr₁₋ₓTiO₃, ZrO₂₅, ZrₓSi₁₋ₓO_{y}, HfₓSi₁-ₓO_{y}, AlₓZr₁₋ₓO₂, Pr₂O₃ or combinations thereof. Said high-k dielectric may usually be deposited by chemical-vapor-deposition (CVD) techniques. Most commonly used are metal organic CVD (MOCVD) and atomic layer deposition (ALD). Also physical vapor deposition (PVD) can be used. Alternatively, said first dielectric material 202 may be deposited with other suitable deposition techniques known to a person skilled in the art.

The first dielectric material 202 may alternatively be another dielectric material such as for example Si₃N₄, SiO₂, SiON, or any other silicon-based dielectric. The deposition of said first dielectric material 202 may then be done by oxidation, for example UV oxidation, plasma oxidation, rapid thermal oxidation.

The first dielectric material 202 may preferably comprise an equivalent oxide thickness (EOT) in the range of 2Å to 30Å, in the range of 2Å to 20Å, in the range of 2Å to 10Å. For a gate dielectric with thickness T and relative dielectric constant k, the EOT is defined by EOT = T/(k/3.9), wherein 3.9 is the relative dielectric constant of thermal silicon dioxide. Thus for a MOSFET with a gate dielectric of thickness T, the ideal gate capacitance per unit area is the same as that of a similar MOSFET, but with a gate dielectric made up of thermal silicon dioxide with a thickness EOT. As an example, a first dielectric material 202 with a relative permittivity of 16 enables a physical thickness of about 4.1 nm to obtain an EOT of 1 nm.

Said first dielectric material 202 is deposited on both the at least first and at least second region 210a, 210b of said substrate 200 and is also referred to as the host dielectric material. Said first dielectric material 202 acts as a host dielectric material which remains in place for the complete semiconductor device, i.e. on both the first region 210a and the second region 210b. With host dielectric material is meant that the dielectric material is used for the main purpose as a control electrode dielectric, e.g. gate dielectric, in a semiconductor device, namely as a dielectric barrier between the control electrode and the channel region of the semiconductor device.

Next, to improve the electrical characteristics of the first dielectric material 202, post-deposition annealing (PDA) may be performed.

In a next step according to the present embodiment of the invention a patterned sacrificial layer 204 is provided on said first dielectric material 202 (FIG.2A). One purpose of this patterned sacrificial layer 204 is to protect the underlying dielectric material (according to the present embodiment the first dielectric material 202) from subsequent process steps, such as for example during patterning of a second dielectric material (see further). From prior art, it is known that most dielectric materials may be damaged significantly if the material is susceptible to the etch chemical used to pattern the sacrificial layer 204. This means that in any subsequent process step comprising the step of removing part of said sacrificial layer 204, the removal of said sacrificial layer 204 must be such that it can be done selective with respect to the underlying dielectric material, otherwise said without damage to the underlying dielectric material, according to the present embodiment the first dielectric material 202, i.e. the host dielectric material. The chemistry necessary for removing said sacrificial layer 204 should thus be adapted to the underlying dielectric material used. With 'sacrificial' is meant that the layer does not have any function for the proper working of the semiconductor device formed by the method according to embodiments of the present invention. In other words, the sacrificial layer 204 is not necessary for the proper electrical working of the semiconductor device. The sacrificial layer 204 serves as an aid in the process flow or in the different steps of the method according to the present embodiment. It is an advantage of the present invention that the sacrificial layer 204 is used to prevent damage to the underlying material, i.e. according to the present embodiment the underlying first dielectric material 202, i.e the underlying host dielectric material during following process steps such as etching or removal steps.

According to embodiments of the invention the sacrificial layer 204 may comprise any material that can be removed without damaging the underlying dielectric material, according to the present embodiment the first dielectric material 202. More preferably the sacrificial layer 204 may comprise TiN or Ge or amorphous carbon.

The thickness of said sacrificial layer 204 may be in the range of 5 to 100 nm, depending on the chemistry which is used to remove said sacrificial layer 204. For example, when said sacrificial layer 204 is removed by wet etching, which is selective to the underlying dielectric material, the thickness of said sacrificial layer 204 may preferably be in the range of 5 to 30 nm. For example, when said sacrificial layer 204 is removed by lift-off, which is selective to the underlying dielectric material, the thickness of said sacrificial layer 204 may preferably be thicker, more specifically in the range of 10 to 100 nm.

Said sacrificial layer 204 may usually be deposited by CVD, ALD, or PVD techniques. Alternatively said sacrificial layer 204 may be deposited with other suitable low temperature deposition techniques known to a person skilled in the art. After deposition of said sacrificial layer 204, the sacrificial layer 204 is in direct contact with the underlying first dielectric material 202. The first dielectric material 202 is thus positioned in between the substrate 200 and the sacrificial layer 204.

Said sacrificial layer 204 needs to be patterned such that the sacrificial layer 204 only remains in the first region 210a of said substrate and is thus removed from said second region 210b of said substrate (FIG. 2B). In other words, according to the present embodiment, the patterned sacrificial layer 204 covers the first dielectric material 202 in the first region 210a, but not the first dielectric material 202 in the second region 210b of the substrate 200. For patterning said sacrificial layer 204 a masking material 205 may be deposited on said sacrificial layer 204, such as for example a resist 205, followed by a lithographic step. This lithographic step may comprise exposing the resist 205 using a mask, followed by patterning the exposed region such that said exposed region (i.e. in the present embodiment said second region 210b) is removed. Alternatively and depending on the kind of lithography used, the first region 210a may be exposed and the unexposed part of the resist, i.e. the resist in the second region 210b, may be removed. After said lithographic step, said sacrificial layer 204 can be easily removed from said second region 210b by, for example, using an etching step. Preferably wet etching may be used to remove the sacrificial layer 204 from the second region 210b. According to the present invention, said etching chemistry is preferably such that said underlying first dielectric material 202 is not damaged during the etching step.

After said step of patterning said sacrificial layer 204, said masking material 205, e.g. resist, may be removed, e.g. may be stripped. After the removal, e.g. stripping, is complete, a rinse with deionized water may be performed to remove any remaining chemicals or resist material.

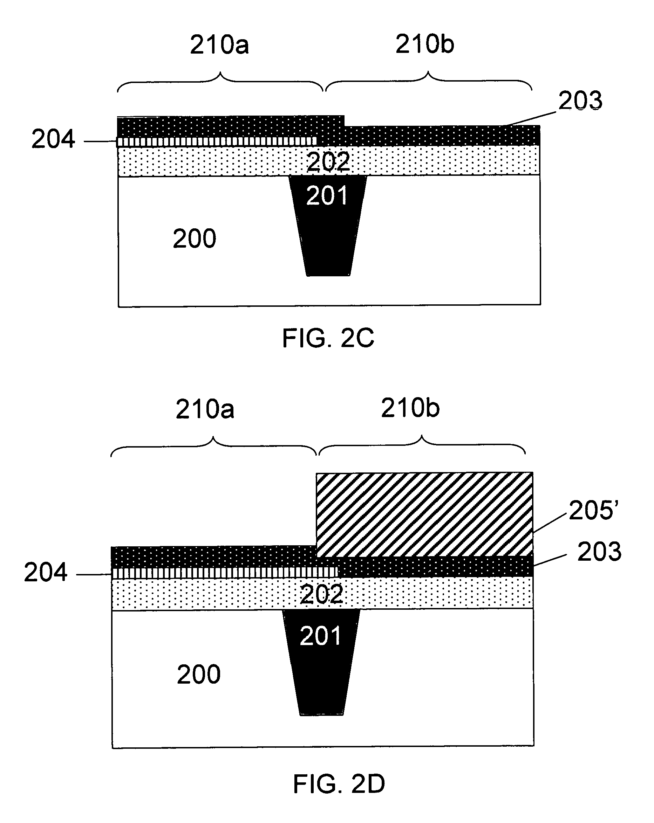

In a next step according to the present embodiment of the invention a second dielectric material 203 is provided on and in contact with said patterned sacrificial layer 204 in said first region 210a and on and in contact with said first gate dielectric 202 in said second region 210b (FIG. 2C). In other words, the second dielectric material 203 is covering the patterned sacrificial layer 204 in the first region 210a and is covering the first dielectric material 202 in the second region 210b of the substrate 200. Said second dielectric material 203 may typically be deposited by CVD, ALD, or PVD techniques. Alternatively said second dielectric material 203 may be deposited with other suitable low temperature deposition techniques known to a person skilled in the art. After the step of providing the second dielectric material 203, said patterned sacrificial layer 204 is in between said first dielectric material 202 and said second dielectric material 203 in said first region 210a. After the step of providing the second dielectric material 203, said second dielectric material 203 is directly in contact with said first dielectric material 202 in said second region 210b.

According to an embodiment of the present invention said second dielectric material 203 may comprise a dielectric material which can tune the workfunction of a gate electrode which is formed on top of said first dielectric material 202 in a subsequent process step. Such a dielectric material is often referred to as dielectric capping layer.

Said dielectric material may comprise LaO(N), A10(N), AlN, DyO(N), ScO(N), GdO(N), CeO(N), TbO(N), ErO(N), YbO(N) or any combination thereof or any other dielectric material which can tune the workfunction of a dielectric/metal interface, e.g. a dielectric/metal control electrode interface, e.g. a dielectric/metal gate electrode interface.

The second dielectric material 203 may preferably comprise an equivalent oxide thickness (EOT) in the range of 2Å to 10Å, in the range of 2Å to 5Å.

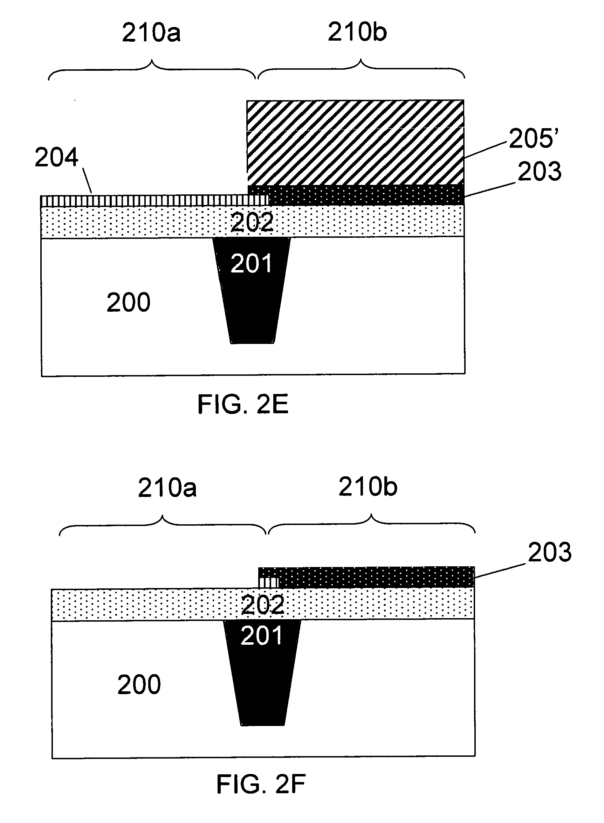

In a next step according to the present embodiment of the invention said second dielectric material 203 is patterned such that said second dielectric material 203 is removed in said first region 210a but that a patterned second dielectric material 203 remains on and in contact with said first dielectric material 202 in said second region 210b (FIG. 2D, 2E, 2F). For patterning said second dielectric material 203 a masking material 205' may be deposited on said second dielectric layer 203, such as for example resist, followed by a lithographic step (FIG. 2D). This lithographic step may comprise exposing the resist using a mask, followed by patterning the exposed region such that said exposed region (i.e. said first region 210a) is removed (FIG. 2E). Alternatively and depending on the kind of lithography used, the second region 210b may be exposed and the unexposed part of the resist, i.e. the resist in the first region 210a, may be removed. After said lithographic step, said second dielectric material 203 may be etched using a dry or wet etching technique depending on the material (FIG. 2E). This etching step of said second dielectric material 203 can be done without damaging the first dielectric material 202, since, in the first region 210a, the sacrificial layer 204 is in between said first 202 and second dielectric material 203. The etching of said second dielectric material 203 is selectively performed with respect to the sacrificial layer 204 and will stop on said sacrificial layer 204. It is known that certain dielectric materials cannot be removed without damaging the underlying dielectric material. By using a sacrificial layer in between, according to the present invention, this problem can be circumvented.

In a next step in the method according to present embodiment of the invention said patterned sacrificial layer 204 is removed (FIG. 2F). After patterning of said second dielectric material 203, said underlying sacrificial layer 204 can be easily removed from said first region 210a by using, for example, an etching step. Preferably wet etching is used to remove the sacrificial layer 204. Said etching chemistry is such that said underlying first dielectric material 202 is not damaged during the etching step. After said step of removing the sacrificial layer, the first region 210a comprises the first dielectric material 202 and the second region 210b comprises the first dielectric material 202 with the second dielectric material 203 on top of the first dielectric material 202 (FIG 2F).

Alternatively patterning of said second dielectric material 203 and removing the sacrificial layer 204 in the first region 210a may be performed at the same time. This may be done by a lift off of said sacrificial layer 204 in said first region 210a. When lifting off the sacrificial layer 204 in said first region 210a also the overlying portion of the second dielectric material 203 will be lifted off. Thus, the first dielectric material 202 is left in said first region 210a (and said second region 210b) and the second dielectric material 203 is only left on and in contact with said first dielectric material 202 in said second region 210b.

According to embodiments of the present invention a first electrode, e.g. a first gate electrode, may be formed on and in contact with said first dielectric material 202 in said first region 210a and a second electrode, e.g. a second gate electrode, may be formed on and in contact with said second dielectric material 203 in said second region 210b after said step of removing said patterned sacrificial layer 204.

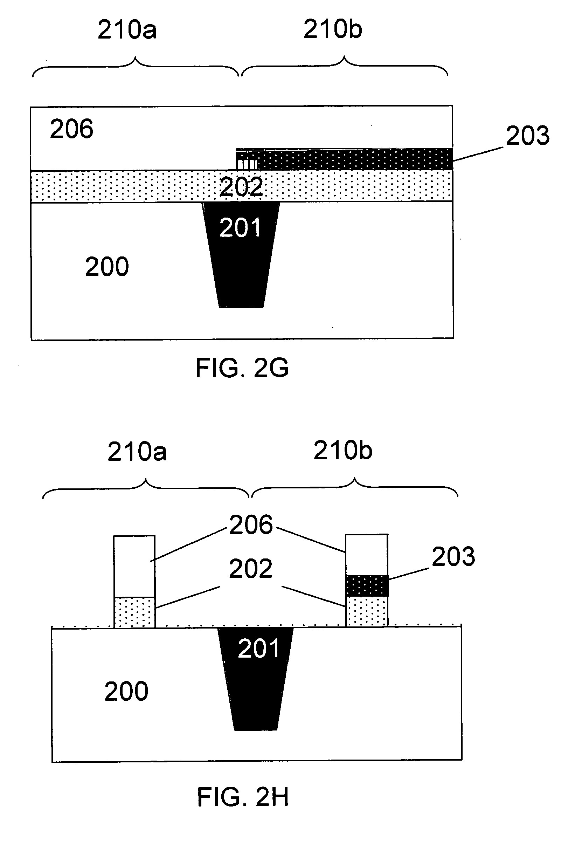

According to an embodiment of the present invention the first electrode may be the same as the second electrode, or in other words the first and second electrode, e.g. the first and second gate electrode, may be formed of a same layer of electrode material, e.g. gate material. Thus alternatively a gate electrode 206 may be formed on and in contact with said first dielectric material 202 in said first region 210a and on and in contact with said second dielectric material 203 in said second region 210b after said step of removing said patterned sacrificial layer 204 (FIG. 2G).

Said first and/or second gate electrode material 206 may comprise a metal comprising material to form a metal gate. With metal comprising material is understood metals, metal alloys, metal silicides, conductive metal nitrides, conductive metal oxides,... For example, the metal comprising material may comprise Ta, Hf, Mo, W or Ru or may comprise Ta-based metals such as TaCₓN_{y}.

Depending on the metal comprising material used, the workfunction of said metal comprising material may be similar to the workfunction of a conventional p-type doped semiconductor or to the workfunction of a conventional n-type doped semiconductor. For example nickel (Ni), Ruthenium oxide (RuO), and molybdenum nitride (MoN) have a workfunction similar to a p-type doped semiconductor material. For example ruthenium (Ru), zirconium (Zr), niobium (Nb), tantalum (Ta), titanium silicide (TiSi₂) have a workfunction similar to a n-type doped semiconductor material. If, for example, said first region 210a will comprise an NMOS transistor of said semiconductor device and the second region 210b will comprise a PMOS transistor of said semiconductor device, an n-type metal gate electrode 206 may be deposited on both said first and second region 210a, 210b. In order to tune the workfunction of said n-type metal gate electrode 206 in the PMOS region (said second region) the second dielectric material 203 is deposited on said first dielectric material 202.

Said gate electrode 206 may alternatively comprise polysilicon or may be a fully silicided (FUSI) metal gate. In FUSI technology, a thin polysilicon gate is deposited as in the conventional CMOS process. Next a metal (e.g. nickel or hafnium) is then deposited and followed by rapid thermal anneal (RTA) to fully silicide the film.

After depositing a gate electrode 206 further process steps may be performed as known in conventional CMOS processing for a person skilled in the art (FIG. 2H). Said process steps may comprise patterning said gate electrode 206 and the first dielectric material 202 and second dielectric material 203, implantation steps to form source and drain regions in said first region 210a and said second region 210b, formation of spacers aside of the gate electrode 206, ...

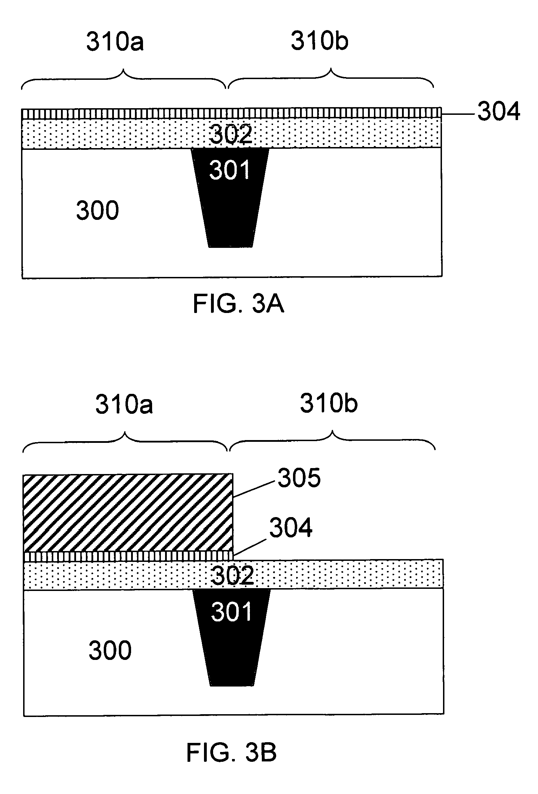

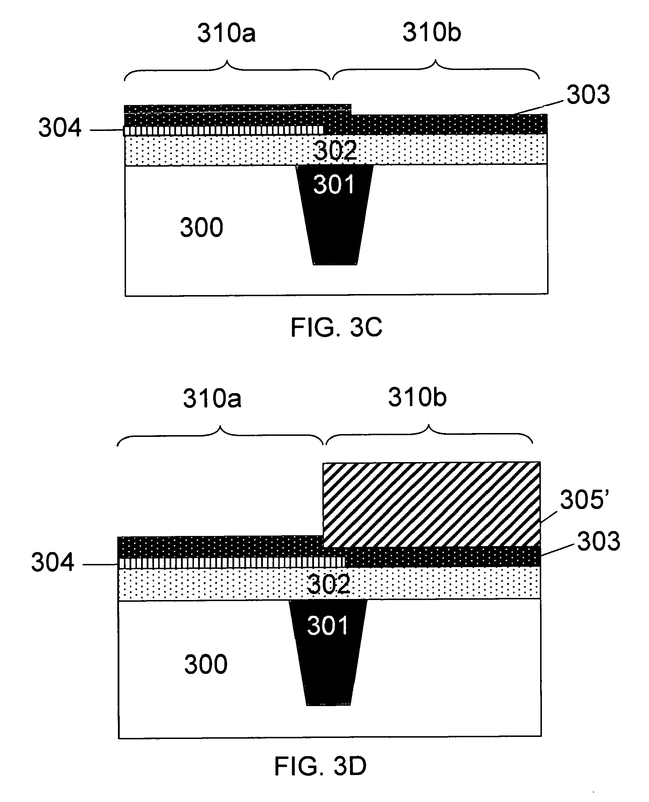

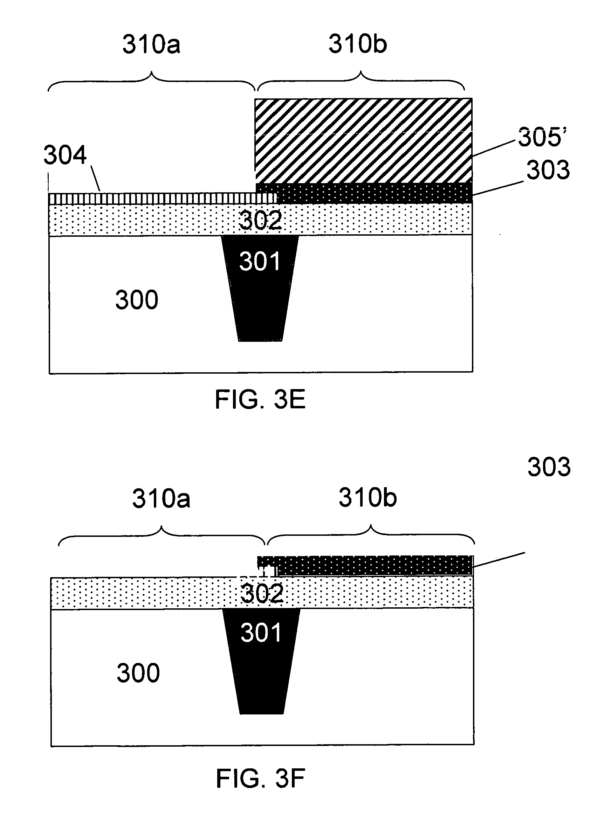

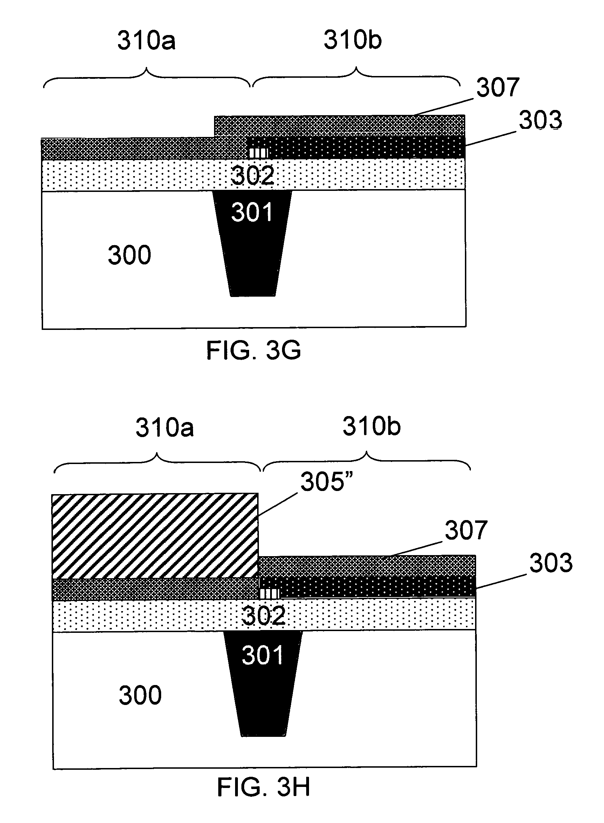

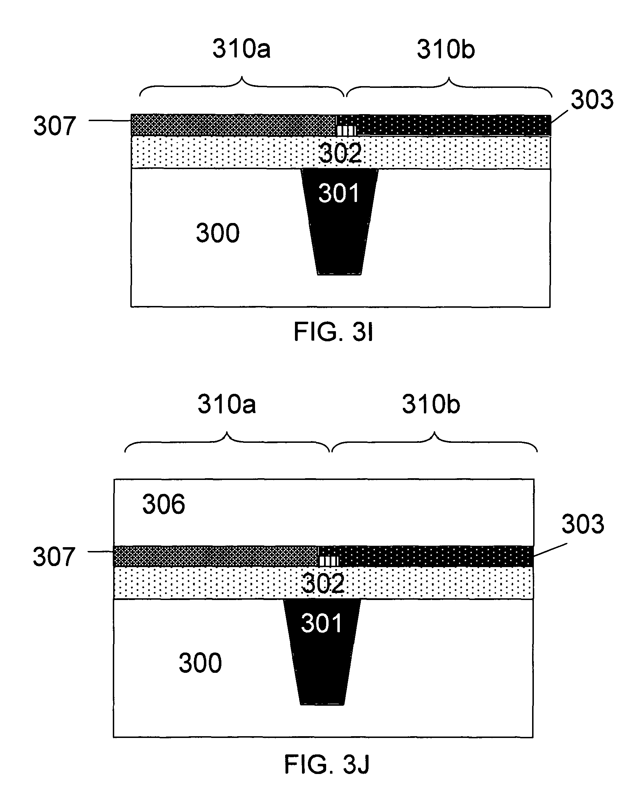

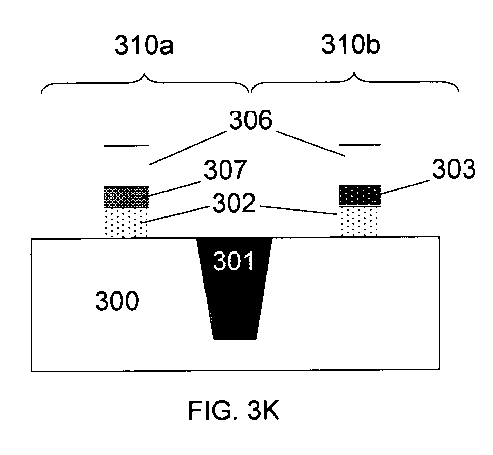

According to other embodiments of the present invention additionally also a third dielectric material may be provided and patterned such that said patterned third dielectric material remains on and in contact with said first dielectric material 202 in said first region 210a (FIG 3A-K). A third dielectric material may be provided in between the first dielectric material and the first electrode in the first region. The first steps of the method according to this embodiment are similar to the steps performed in method as described in the first embodiment, i.e. the steps of defining a first 310a and second region 310b in a substrate 300 (FIG. 3A), forming a first dielectric material 302 on said substrate 300 (FIG. 3A), patterning a sacrificial layer 304 such that said patterned sacrificial layer 304 is in contact with said underlying first dielectric material 302 in said first region 310a but not in said second region 310b (FIG. 3B), forming a second dielectric material 303 on and in contact with said patterned sacrificial layer 304 in said first region 310a and on and in contact with said first gate dielectric 302 in said second region 310b (FIG. 3C), patterning said second dielectric material 303 such that said patterned second dielectric material 303 remains on and in contact with said first dielectric material 304 in said second region 310b (FIG. 3D-E), removing said patterned sacrificial layer 304 (FIG. 3F). After performing the aforementioned steps, a third dielectric material 307 may be provided on and in contact with said first dielectric material 302 in said first region 310a and on and in contact with said second dielectric material 303 in said second region 310b(FIG. 3G). The third dielectric material is used to adjust the workfunction in the first region to the desired value.

According to embodiments of the present invention said third dielectric material 307 may comprise a dielectric material which can tune the workfunction of the gate electrode which is formed on top of said first dielectric material 302 in the first region 210a in a subsequent process step. Such a dielectric material is often referred to as dielectric capping layer.

Said third dielectric material may comprise LaO(N), AlO(N), AlN, DyO(N), ScO(N), GdO(N), CeO(N), TbO(N), ErO(N), YbO(N) or any combination thereof or any other dielectric material which can tune the workfunction of a metal gate electrode material.

The third dielectric material 307 may preferably comprise an equivalent oxide thickness (EOT) in the range of 2Å to 10Å, in the range of 2Å to 5Å.

After providing said third dielectric material 307, said third dielectric material 307 may be patterned such that said patterned third dielectric material 307 remains on and in contact with said first dielectric material 302 in said first region 310a (FIG. 3H-I). In other words, after patterning the third dielectric material 307, the patterned third dielectric material 307 covers the first dielectric material 302 in the first region 302 but not the second dielectric material 303 in the second region 310b. For patterning said third dielectric material 307 a masking material 305", such as for example a resist, may be deposited on said third dielectric layer 307 in said first region 310a followed by a lithographic step (FIG. 3H). This lithographic step may comprise exposing the resist using a mask, followed by patterning the exposed region such that said exposed region (i.e. said second region 310b) is removed. Alternatively and depending on the kind of lithography used, the first region 210a may be exposed and the unexposed part of the resist 305", i.e. the resist in the second region 210a, may be removed. After said lithographic step, said third dielectric material 307 may be etched using a dry or wet etching technique depending on the material (FIG. 3H). The etching of said third dielectric material 307 is selectively performed with respect to the second dielectric material 303 and will thus stop on said second dielectric material 303. After this patterning step, said first region 310a comprises the third dielectric material 307 in contact with said underlying first dielectric material 302; said second region 310b comprises the second dielectric material 303 in contact with said underlying first dielectric material 302.

According to embodiments of the present invention a control electrode, e.g gate electrode 306, may be formed on and in contact with said third dielectric material 307 in said first region 310a and on and in contact with said second dielectric material 303 in said second region 210b (FIG. 3J).

Said gate electrode material 306 may comprise a metal comprising material to form a metal gate. With metal comprising material is understood metals, metal alloys, metal silicides, conductive metal nitrides, conductive metal oxides,... Depending on the metal, the workfunction of said metal comprising material may be similar to the workfunction of a conventional p-type doped semiconductor or to the workfunction of a conventional n-type doped semiconductor. For example nickel (Ni), Ruthenium oxide (RuO), and molybdenum nitride (MoN) have a workfunction similar to a p-type doped semiconductor material. For example ruthenium (Ru), zirconium (Zr), niobium (Nb), tantalum (Ta), titanium silicide (TiSi₂) have a workfunction similar to a n-type doped semiconductor material. If, for example, said first region 310a comprises an NMOS transistor of said semiconductor device and the second region 310b comprises a PMOS transistor of said semiconductor device, an n-type metal gate electrode 306 may be deposited on both said first and second region 310a, 310b. In order to tune the workfunction of said n-type metal gate electrode 306 in the PMOS region (said second region) a second dielectric material 303 is deposited on said first dielectric material 302. If necessary the workfunction of said n-type metal gate electrode 306 in the NMOS region (first region 310a) may be tuned by the third dielectric material 307 which is deposited on said first dielectric material 302.

Said gate electrode 306 may alternatively comprise polysilicon or may be a fully silicided (FUSI) metal gate. In FUSI technology, a thin polysilicon gate is deposited as in the conventional CMOS process. Next a metal (nickel or hafnium) is then deposited and followed by rapid thermal anneal (RTA) to fully silicide the film.

After said step of depositing a gate electrode 306 further process steps may be performed as known in conventional CMOS processing for a person skilled in the art (FIG. 3K). Said process steps may comprise patterning said gate electrode 306 and the first dielectric material 302, second dielectric material 303 and third dielectric material 307, implantation steps to form source and drain regions in said first region 310a and said second region 310b, formation of spacers aside of the gate electrode 306, ...

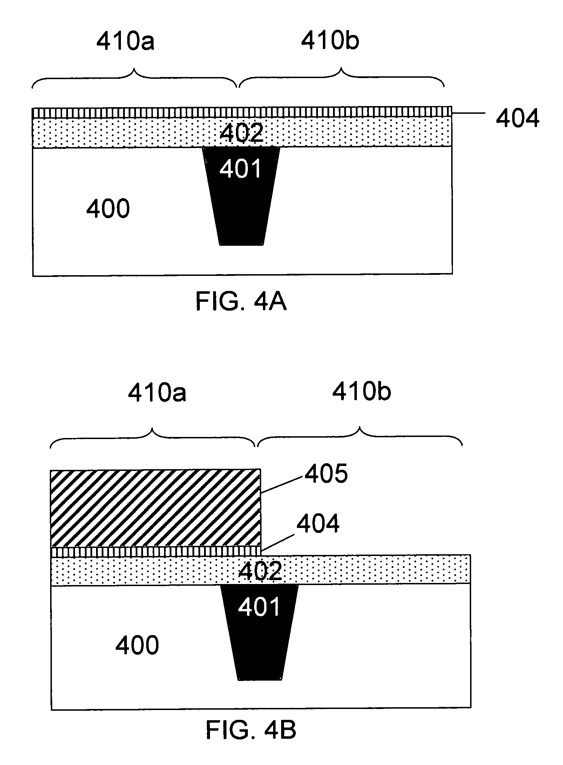

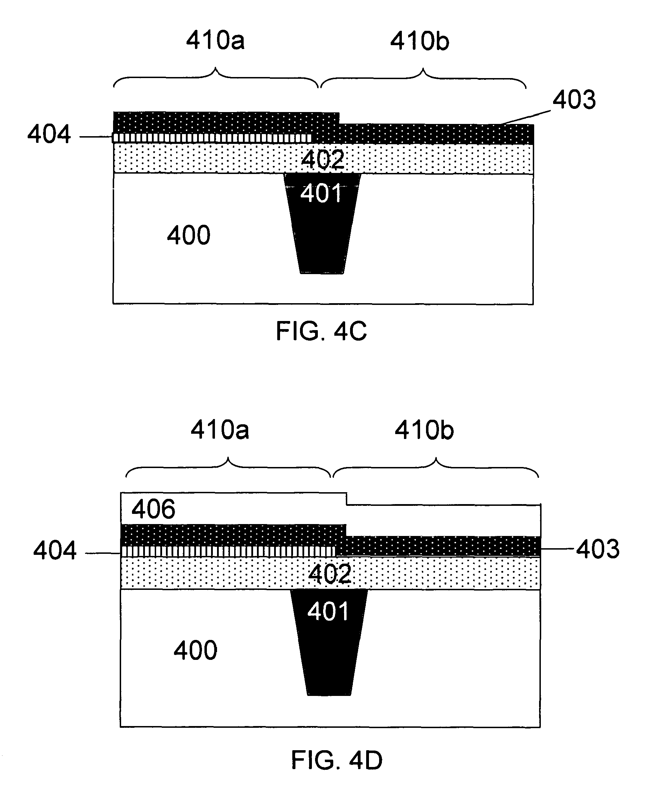

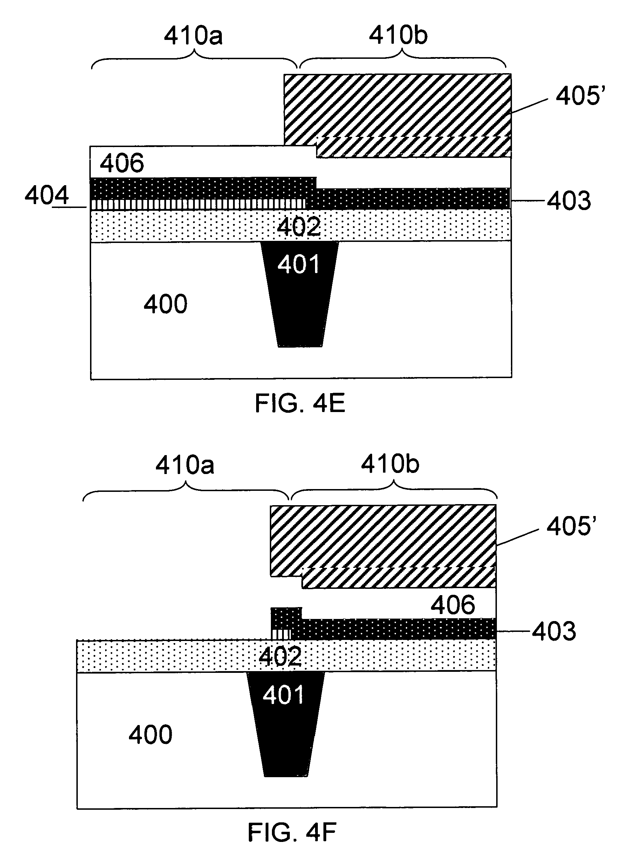

In yet another embodiment according to the present invention a first gate electrode may be formed on and in contact with said second dielectric material 403 after providing said second dielectric material 403 (FIG. 4A-I). The first steps of the method according to this embodiment are similar to the steps as described for the first and second embodiments, i.e. the steps of defining a first 410a and second region 410b in a substrate 400 (FIG. 4A), forming a first dielectric material 402 on said substrate 400 (FIG. 4A), patterning a sacrificial layer 404 such that said patterned sacrificial layer 404 is in contact with said underlying first dielectric material 402 in said first region 410a (FIG. 4B), forming a second dielectric material 403 on and in contact with said patterned sacrificial layer 404 in said first region 410a and on and in contact with said first dielectric material 402 in said second region 410b (FIG. 4C). After performing the aforementioned steps, a first gate electrode 406 may be formed on and in contact with said second dielectric material 403 over the entire substrate 200, i.e. according to the present embodiment over the first region 410a and second region 410b (FIG. 4D).

Said first gate electrode material 406 may comprise a metal comprising material to form a metal gate. With metal comprising material is understood metals, metal alloys, conductive metal silicides, conductive metal nitrides, metal oxides,... Depending on the metal comprising material, the workfunction of said metal comprising material may be similar to the workfunction of a conventional p-type doped semiconductor or to the workfunction of a conventional n-type doped semiconductor. For example nickel (Ni), Ruthenium oxide (Ru0), and molybdenum nitride (MoN) have a workfunction similar to a p-type doped semiconductor material. For example ruthenium (Ru), zirconium (Zr), niobium (Nb), tantalum (Ta), titanium silicide (TiSi₂) have a workfunction similar to a n-type doped semiconductor material. If, for example, said first region 410a will comprise an NMOS transistor of said semiconductor device and the second region 410b will comprise a PMOS transistor of said semiconductor device, an n-type metal gate electrode 406 may be deposited on said NMOS (first) region and a p-type metal gate electrode 406 may be deposited on said PMOS (second) region. In order to tune the workfunction of said p-type metal gate electrode 406, a second dielectric material 403 is deposited on said first dielectric material 402 in said second region 410b.

Said first gate electrode 406 may alternatively comprise polysilicon or may be a fully silicided (FUSI) metal gate. In FUSI technology, a thin polysilicon gate may be deposited as in the conventional CMOS process. Next metal (nickel or hafnium) is then deposited and followed by rapid thermal anneal (RTA) to fully silicide the film.

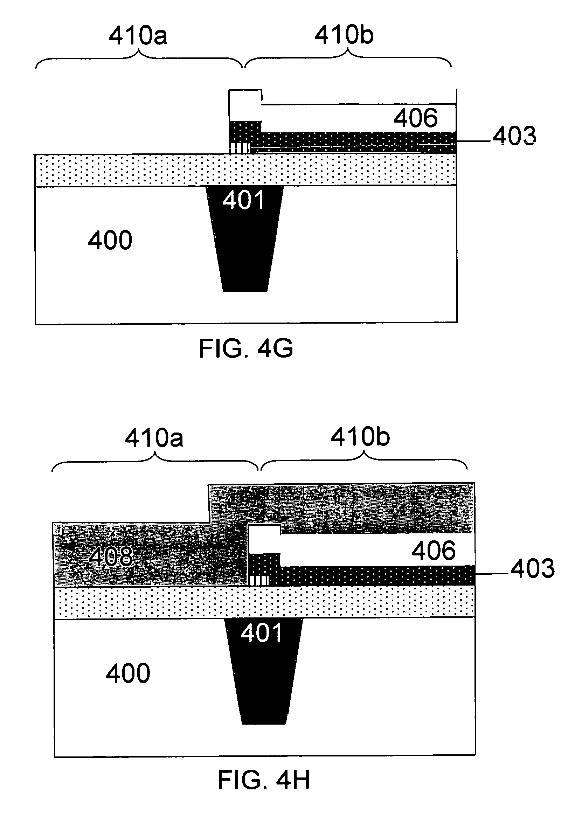

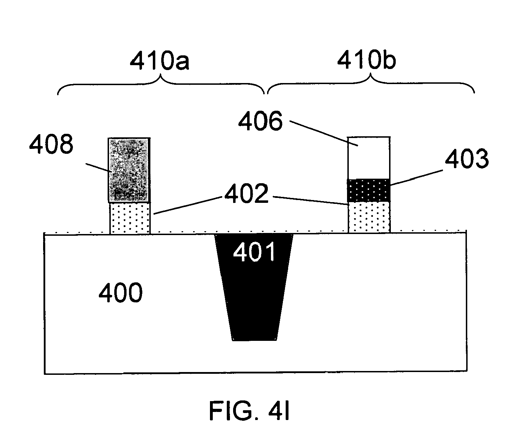

In a next step, according to the present embodiment, said first gate electrode 406 may be patterned in the same step of patterning said second dielectric material 403, such that said first gate electrode 406 remains on and in contact with said second dielectric material 403 in said second region 410b (FIG. 4E-F). This patterning step may be done in one step by lifting off said sacrificial layer 404 in said first region 410a after depositing a masking material 405' on said first gate electrode 406 in said second region 410b, such as for example a resist, followed by a lithographic step. In the lift-off process also the second dielectric material 403 and the first gate electrode material 406 will be removed. Alternatively, different etching steps may be performed. For example, said first gate electrode 406 may be etched first, next said second dielectric material 403 may be etched and finally said sacrificial layer 404 is removed by, for example, etching. The etch steps may comprise wet or dry etching depending on the material of the sacrificial layer 404. The advantage of this method is that the underlying first dielectric material 402 will not be damaged during the etching steps of the first gate electrode 406 and the second dielectric material 403 due to the protective sacrificial layer 404 which is positioned in between said first dielectric material 402 and said second dielectric material 403. In addition, another advantage is that the second dielectric material is protected during the resist patterning and resist stripping by the first gate electrode 406. After said patterning step the resist 305' may be stripped (FIG. 4G) and said first region 410a comprises said first dielectric material 402; said second region 410b comprises the first gate electrode 406 on and in contact with the second dielectric material 403 in contact with said underlying first dielectric material 402.

According to an embodiment of the present invention a second gate electrode 408 may be formed (FIG. 4H). Said second gate electrode 408 may comprise a metal, polysilicon or a fully silicided metal gate, which need not to be the same as the first gate electrode 406 which offers additional freedom in tuning the workfunction.

After said step of depositing a first 406 and/or a second 408 gate electrode further process steps may be performed as known in conventional CMOS processing for a person skilled in the art (FIG. 4I). Said process steps may comprise patterning said gate electrode 406, implantation steps to form source and drain regions in said first region 410a and said second region (410b), formation of spacers aside of the gate electrode 406, 408, ...

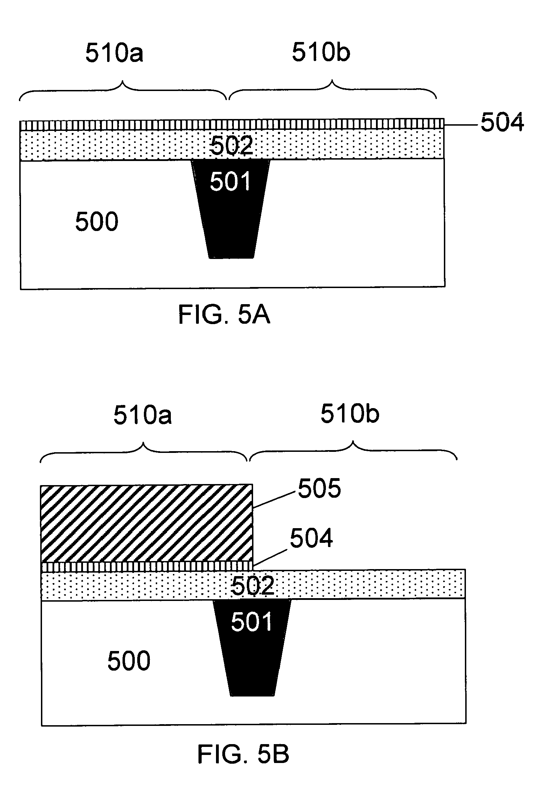

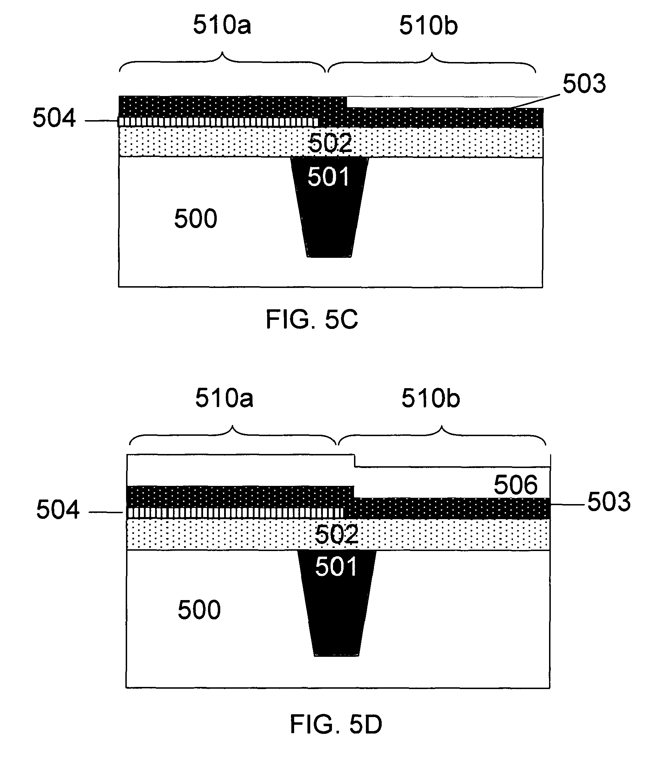

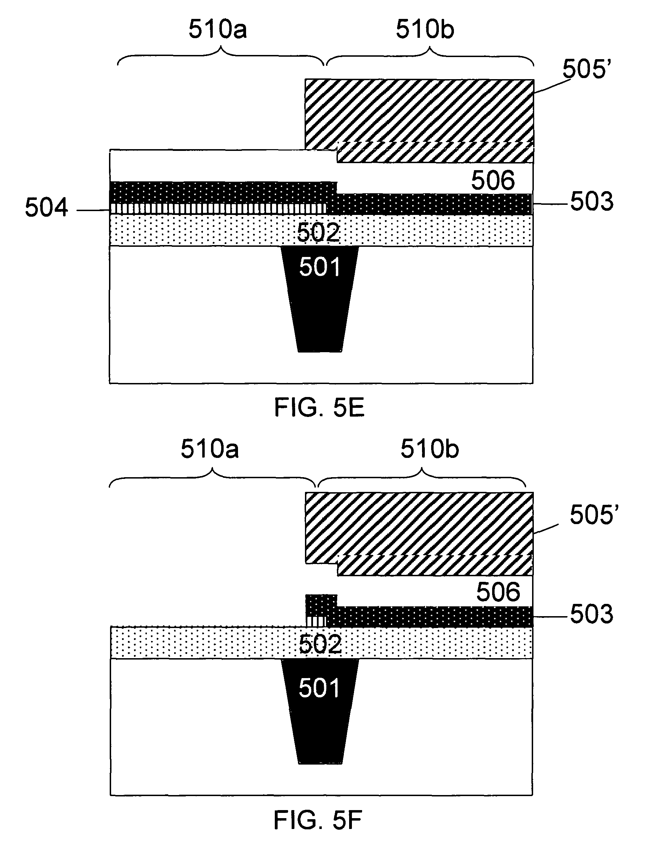

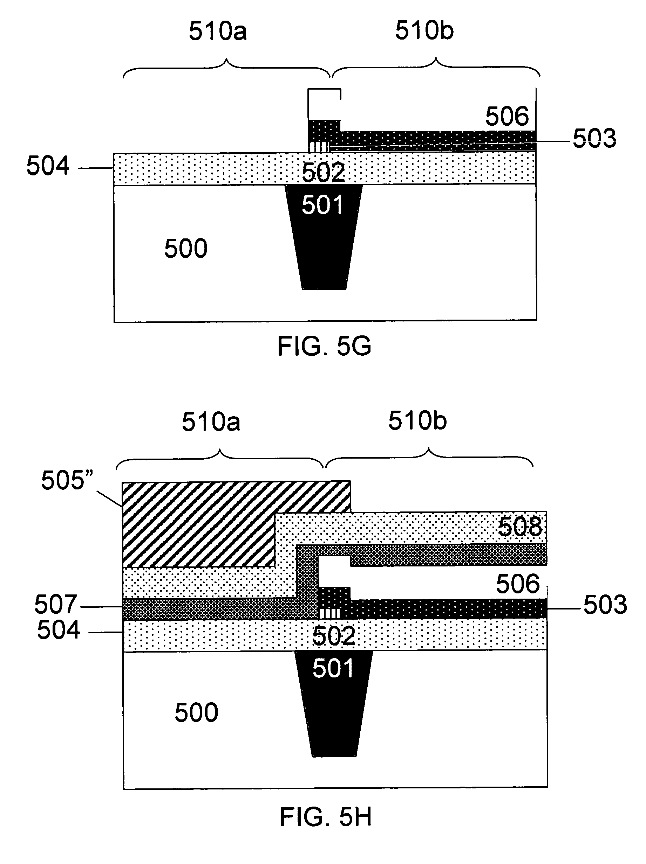

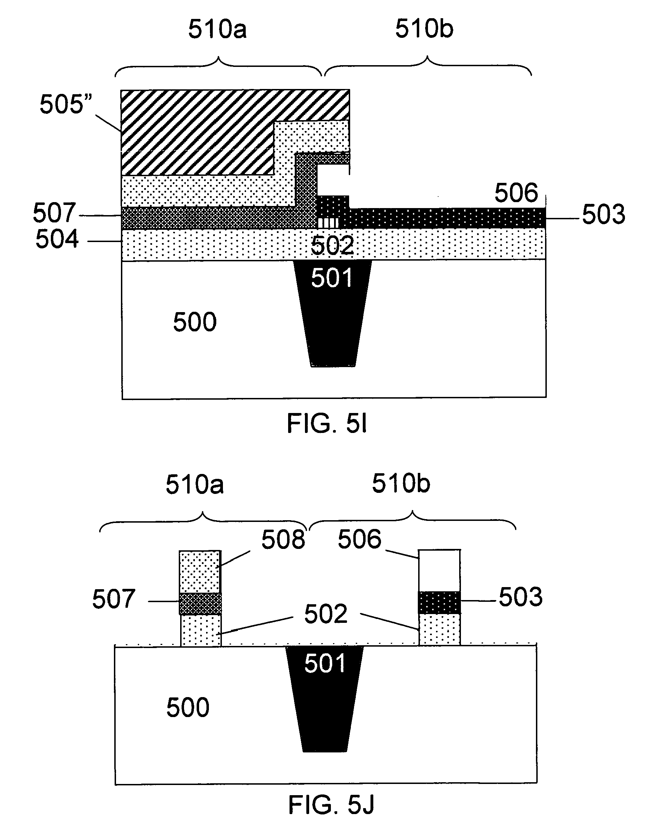

According to another embodiment of the present invention, a third dielectric material 507 may be deposited on the first dielectric material 502 to also tune the workfunction of said f.e. n-type metal gate electrode in the NMOS region (i.e. the first region) (FIG. 5A-J). In other words, multiple dielectric materials are provided and multiple control electrodes are provided, wherein the third dielectric material is for tuning the first control electrode in the first region and wherein a second dielectric material is for tuning the second control electrode in the second region. The first steps of the method according to this embodiment are similar to the steps as described for the first and second embodiments, i.e. the steps of defining a first region 510a and second region 510b in a substrate 400 (FIG. 5A), forming a first dielectric material 502, i.e the host dielectric material, on said substrate 500 (FIG. 5A), patterning a sacrificial layer 504 such that said patterned sacrificial layer 504 is in contact with said underlying first dielectric material 502 in said first region 510a but does not cover the first dielectric material 502 in the second region 510b (FIG. 5B), providing a second dielectric material 503 on and in contact with said patterned sacrificial layer 504 in said first region 510a and on and in contact with said first dielectric material 502 in said second region 510b (FIG. 5C). After providing the second dielectric material 503, a second gate electrode 506 may be deposited, the second gate electrode 506 covering the first and second region 510a, 510b (see FIG. 5D). Next, the second gate electrode 506 may be patterned such that the patterned second gate electrode 506 covers the second dielectric material 503 in the second region 510b but not the first dielectric material 502 in the first region 510a (see FIG. 5F). Patterning may be performed by providing a mask 505', e.g. a resist, covering the second gate electrode 506 in the second region 510b but not in the first region 510a (see FIG. 5E). After patterning the second gate electrode 506 the mask 505' may be removed (see FIG. 5G).

After the step of depositing and patterning the second gate electrode 506 and before the step of depositing a first gate electrode 508, a third dielectric material 507 may be provided (see FIG. 5H) and patterned (see FIG. 5I), such that the patterned third dielectric material 507 covers the first dielectric material 502 in the first region 510a but not the patterned second gate electrode 506 in the second region 510b. The patterning of said third dielectric material may be performed simultaneously with the patterning of the first gate electrode (see FIG. 5I). Said patterning may be performed using a masking material, such as resist 505" and a lithographic step. After said lithographic step, said third dielectric material 507 and said first gate electrode material 508 in said second region 510b may be removed for example by etching, which is selective to the second gate electrode material 506.

After performing the above steps, further process steps may be performed as known in conventional CMOS processing for a person skilled in the art. Said process steps may comprise patterning said gate electrodes 506, 508 and the first dielectric material 502, second dielectric material 503 and third dielectric material 507 (see FIG. 5I), implantation steps to form source and drain regions in said first region 410a and said second region (410b), formation of spacers aside of the gate electrode 406, 408, ... .

By the above method embodiments, a semiconductor device may be manufactured with a first region 510a comprising a first gate electrode 508 on and in contact with the underlying third dielectric material 507 on and in contact with the first dielectric material 502 and a second region 510b comprising a second gate electrode 506 on and in contact with the second dielectric material 503 on and in contact with the first dielectric material 502.

It is to be understood that although preferred embodiments, specific constructions and configurations, as well as materials, have been discussed herein for devices according to the present invention, various changes or modifications in form and detail may be made without departing from the scope and spirit of this invention. For example, steps may be added or deleted to methods described within the scope of the present invention.

## Claims

1. Method of manufacturing a semiconductor device comprising:
- providing a first dielectric material (202, 302, 402, 502) on a substrate (200, 300, 400, 500);
- providing a patterned sacrificial layer (204, 304, 404, 504) covering the first dielectric material (200, 300, 400, 500) in at least a first region (210a, 310a, 410a, 510a) of the substrate (200, 300, 400, 500);
- providing a second dielectric material (203, 303, 403, 503) covering the patterned sacrificial layer (204, 304, 404, 504) in the first region (210a, 310a, 410a, 510a) and covering the first dielectric material (202, 302, 402, 502) in at least a second region (210b) of the substrate (200, 300, 400, 500), the second region 210b being different from the first region (210a, 310a, 410a, 510a);
- patterning the second dielectric material (203, 303, 403, 503) such that the patterned second dielectric material covers the first dielectric material (202, 302, 402, 502) in the second region (210b) but not the patterned sacrificial layer (204, 304, 404, 504) in the first region (210a, 310a, 410a, 510a); and
- removing the patterned sacrificial layer (204, 304, 404, 504).

2. Method of manufacturing a semiconductor device according to claim 1, wherein removing the patterned sacrificial layer (204, 304, 404, 504) is performed without damaging the first dielectric material (202, 302, 402, 502) covered by the sacrificial layer (204, 304, 404, 504).

3. Method of manufacturing a semiconductor device according to claim 1 or 2, further comprising providing a first electrode (206, 306, 408, 508) in the first region (210a, 310a, 410a, 510a) and a second electrode (206, 306, 406, 506) in the second region (210b, 310b, 410b, 510b).

4. Method of manufacturing a semiconductor device according to claim 3, wherein the first electrode (206, 306) and the second electrode (206, 306) are formed of a same layer of electrode material.

5. Method of manufacturing a semiconductor device according to claim 3, wherein the first electrode (408, 508) and the second electrode (406, 506) are formed of different layers of electrode material.

6. Method of manufacturing a semiconductor device according to claim 4 or 5, wherein the electrode material is a metal comprising material.

7. Method of manufacturing a semiconductor device according to claim 3 to 6, further comprising, after providing the second dielectric material (403), forming the second electrode (406) on and in contact with the second dielectric material (403) and patterning the second electrode (406) such that the second electrode (406) covers the second dielectric material 403 in the second region (410b) but not the first dielectric material (403) in the first region (410a), wherein patterning the second electrode (406) and patterning the second dielectric material (403) is performed simultaneously.

8. Method of manufacturing a semiconductor device according to any of claims 1 to 7, wherein the first dielectric material (202, 302, 402, 502) comprises a silicon based dielectric material.

9. Method of manufacturing a semiconductor device according to claim 8, wherein the silicon based dielectric material comprises SiO₂ Si₃N₄ or SiON.

10. Method of manufacturing a semiconductor device according to any of claims 1 to 7, wherein the first dielectric material (202, 302, 402, 502) comprises a high-k dielectric material.

11. Method of manufacturing a semiconductor device according to claim 10, wherein the high-k dielectric material comprises Al₂O₃, Si₃N₄, Gd₂O₃, Yb₂O₃, Dy₂O₃, Nb₂O₅, Y₂O₃, La₂O₃, ZrO₂, HfO₂, TiO₂, Ta₂O₅, SrTiO₃, BaₓSr₁₋ₓTiO₃, ZrO₂₅, ZrₓSi₁₋ₓO_{y}, HfₓSi₁₋ₓO_{y}, AlₓZr₁₋ₓO₂, Pr₂O₃ or any combination thereof.

12. Method of manufacturing a semiconductor device according to any of claims 3 to 11, wherein the second dielectric material (203, 303, 403, 503) comprises a material suitable for tuning the workfunction of the first electrode (206, 306, 408, 508) and/or second electrode (210b, 310b, 410b, 510b).

13. Method of manufacturing a semiconductor device according to any of claims 1 to 12, wherein the second dielectric material (203, 303, 403, 503) comprises LaO(N), AlO(N), AlN, DyO(N), ScO(N), GdO(N), CeO(N), TbO(N), ErO(N), YbO (N) or any combination thereof.

14. Method of manufacturing a semiconductor device according to any of claims 1 to 13, wherein the sacrificial layer (204, 304, 404, 504) comprises TiN, Ge or amorphous carbon.

15. Method of manufacturing a semiconductor device according to any of claims 1 to 14, wherein the first dielectric material (202, 302, 402, 502) has an equivalent oxide thickness in the range of 2 Å to 30 Å.

16. Method of manufacturing a semiconductor device according to any of claims 1 to 15, wherein the second dielectric material (203, 303, 403, 503) has an equivalent oxide thickness in the range of 2 Å to 10 Å.

17. Method of manufacturing a semiconductor device according to any of claims 1 to 16, wherein the sacrificial layer (204, 304, 404, 504) has a thickness in the range of 5 nm to 100 nm.

18. Method of manufacturing a semiconductor device according to any of claims 3 to 17, further comprising providing a third dielectric material (307) in between the first dielectric material (302) and the first electrode (306) in the first region (310a).

19. Method of manufacturing a semiconductor device according to claim 18, wherein providing a third dielectric material (307) comprises:
- providing the third dielectric material (307) covering the first dielectric material (302) in the first region (310a) and covering the second dielectric material (303) in the second region (310b);
- patterning the third dielectric material (307) such that the patterned third dielectric material (307) covers the first dielectric material (302) in the first region (310a) but not the second dielectric material (303) in the second region (310b).

20. Method of manufacturing a semiconductor device according to any of claims 18 to 19, wherein the third dielectric material (307) comprises a material suitable for tuning the workfunction of the first and/or second electrode.

21. Method of manufacturing a semiconductor device according to any of claims 18 to 20, wherein the third dielectric material (307) comprises LaO(N), AlO(N), AlN, DyO(N), ScO(N), GdO(N), CeO(N), TbO(N), ErO(N), YbO(N) or any combination thereof.

22. Method of manufacturing a semiconductor device according to any of claims 18 to 21, wherein the third dielectric material (307) has an equivalent oxide thickness in the range of 2 Å to 10 Å.

## Amended claims

### Amended claims in accordance with Rule 137(2) EPC.

**1.** Method of manufacturing a semiconductor device comprising different semiconductor structures, each structure having a control electrode, the semiconductor device comprising at least a first and a second control electrode dielectric material, the method comprising:
- providing a first control electrode dielectric material (202, 302, 402, 502) on a substrate (200, 300, 400, 500);
**characterized in that** the method furthermore comprises:
- providing a patterned sacrificial layer (204, 304, 404, 504) covering the first control electrode dielectric material (200, 300, 400, 500) in at least a first region (210a, 310a, 410a, 510a) of the substrate (200, 300, 400, 500);
- providing a second control electrode dielectric material (203, 303, 403, 503) covering the patterned sacrificial layer (204, 304, 404, 504) in the first region (210a, 310a, 410a, 510a) and covering the first control electrode dielectric material (202, 302, 402, 502) in at least a second region (210b) of the substrate (200, 300, 400, 500), the second region 210b being different from the first region (210a, 310a, 410a, 510a);
- patterning the second control electrode dielectric material (203, 303, 403, 503) such that the patterned second control electrode dielectric material covers the first control electrode dielectric material (202, 302, 402, 502) in the second region (210b) but not the patterned sacrificial layer (204, 304, 404, 504) in the first region (210a, 310a, 410a, 510a); and
- removing the patterned sacrificial layer (204, 304, 404, 504).

**2.** Method of manufacturing a semiconductor device according to claim 1, wherein removing the patterned sacrificial layer (204, 304, 404, 504) is performed without damaging the first control electrode dielectric material (202, 302, 402, 502) covered by the sacrificial layer (204, 304, 404, 504).

**3.** Method of manufacturing a semiconductor device according to claim 1 or 2, further comprising providing a first control electrode (206, 306, 408, 508) in the first region (210a, 310a, 410a, 510a) and a second control electrode (206, 306, 406, 506) in the second region (210b, 310b, 410b, 510b).

**4.** Method of manufacturing a semiconductor device according to claim 3, wherein the first control electrode (206, 306) and the second control electrode (206, 306) are formed of a same layer of electrode material.

**5.** Method of manufacturing a semiconductor device according to claim 3, wherein the first control electrode (408, 508) and the second control electrode (406, 506) are formed of different layers of electrode material.

**6.** Method of manufacturing a semiconductor device according to claim 4 or 5, wherein the electrode material is a metal comprising material.

**7.** Method of manufacturing a semiconductor device according to claim 3 to 6, further comprising, after providing the second control electrode dielectric material (403), forming the second control electrode (406) on and in contact with the second control electrode dielectric material (403) and patterning the second control electrode (406) such that the second control electrode (406) covers the second control electrode dielectric material 403 in the second region (410b) but not the first control electrode dielectric material (403) in the first region (410a), wherein patterning the second control electrode (406) and patterning the second control electrode dielectric material (403) is performed simultaneously.

**8.** Method of manufacturing a semiconductor device according to any of claims 1 to 7, wherein the first control electrode dielectric material (202, 302, 402, 502) comprises a silicon based dielectric material.

**9.** Method of manufacturing a semiconductor device according to claim 8, wherein the silicon based dielectric material comprises SiO₂, Si₃N₄ or SiON.

**10.** Method of manufacturing a semiconductor device according to any of claims 1 to 7, wherein the first control electrode dielectric material (202, 302, 402, 502) comprises a high-k dielectric material.

**11.** Method of manufacturing a semiconductor device according to claim 10, wherein the high-k dielectric material comprises Al₂O₃, Si₃N₄, Gd₂O₃, Yb₂O₃, Dy₂O₃, Nb₂O₅, Y₂O₃, La₂O₃, ZrO₂, HfO₂, TiO₂, Ta₂O₅, SrTiO₃, BaₓSr₁₋ₓTiO₃, ZrO₂₅, ZrₓSi₁₋ₓO_{y}, HfₓSi₁₋ₓO_{y}, AlₓZr₁₋ₓO₂, Pr₂O₃ or any combination thereof.

**12.** Method of manufacturing a semiconductor device according to any of claims 3 to 11, wherein the second control electrode dielectric material (203, 303, 403, 503) comprises a material suitable for tuning the workfunction of the first control electrode (206, 306, 408, 508) and/or second control electrode (210b, 310b, 410b, 510b).

**13.** Method of manufacturing a semiconductor device according to any of claims 1 to 12, wherein the second control electrode dielectric material (203, 303, 403, 503) comprises LaO(N), AlO(N), AlN, DyO(N), ScO (N), GdO (N), CeO (N), TbO (N), ErO (N), YbO(N) or any combination thereof.

**14.** Method of manufacturing a semiconductor device according to any of claims 1 to 13, wherein the sacrificial layer (204, 304, 404, 504) comprises TiN, Ge or amorphous carbon.

**15.** Method of manufacturing a semiconductor device according to any of claims 1 to 14, wherein the first control electrode dielectric material (202, 302, 402, 502) has an equivalent oxide thickness in the range of 0.2 nm to 3 nm.

**16.** Method of manufacturing a semiconductor device according to any of claims 1 to 15, wherein the second control electrode dielectric material (203, 303, 403, 503) has an equivalent oxide thickness in the range of 0.2 nm to 1 nm.

**17.** Method of manufacturing a semiconductor device according to any of claims 1 to 16, wherein the sacrificial layer (204, 304, 404, 504) has a thickness in the range of 5 nm to 100 nm.

**18.** Method of manufacturing a semiconductor device according to any of claims 3 to 17, further comprising providing a third control electrode dielectric material (307) in between the first control electrode dielectric material (302) and the first control electrode (306) in the first region (310a).

**19.** Method of manufacturing a semiconductor device according to claim 18, wherein providing a third control electrode dielectric material (307) comprises:
- providing the third control electrode dielectric material (307) covering the first control electrode dielectric material (302) in the first region (310a) and covering the second control electrode dielectric material (303) in the second region (310b);
- patterning the third control electrode dielectric material (307) such that the patterned third control electrode dielectric material (307) covers the first control electrode dielectric material (302) in the first region (310a) but not the second control electrode dielectric material (303) in the second region (310b).

**20.** Method of manufacturing a semiconductor device according to any of claims 18 to 19, wherein the third control electrode dielectric material (307) comprises a material suitable for tuning the workfunction of the first and/or second control electrode.

**21.** Method of manufacturing a semiconductor device according to any of claims 18 to 20, wherein the third control electrode dielectric material (307) comprises LaO(N), AlO(N), AlN, DyO(N), ScO(N) GdO(N), CeO(N), TbO(N), ErO(N), YbO(N) or any combination thereof.

**22.** Method of manufacturing a semiconductor device according to any of claims 18 to 21, wherein the third control electrode dielectric material (307) has an equivalent oxide thickness in the range of 0.2 nm to 1 nm.
